# EUROPÄISCHE PATENTSCHRIFT

(11) **EP 2 179 448 B1**
(45) Veröffentlichungstag und Bekanntmachung des Hinweises auf die Patenterteilung: **13.03.2013**
(21) Anmeldenummer: 08785243.0
(22) Anmeldetag: 31.07.2008
(51) Int. Cl.: H01L 31/0224, C23C 18/16

(54) **VERFAHREN ZUR BESCHICHTUNG VON SOLARZELLEN SOWIE VORRICHTUNG HIERFÜR**
METHOD FOR COATING SOLAR CELLS AND DEVICE THEREFOR
PROCEDE ET DISPOSITIF D'ENDUCTION DE CELLULES SOLAIRES

(30) Priorität: 31.07.2007 DE 102007038120
(43) Veröffentlichungstag der Anmeldung: 28.04.2010
(73) Patentinhaber: Gebr. Schmid GmbH, 72250 Freudenstadt (DE)
(72) Erfinder: MAURER, Werner, Andreas, 72250 Freudenstadt (DE); WIDMANN, Thomas, 72296 Oberiflingen (DE)
(74) Vertreter: Patentanwälte Ruff, Wilhelm, Beier, Dauster & Partner
(86) Internationale Anmeldenummer: PCT/EP2008/006301
(87) Internationale Veröffentlichungsnummer: WO 2009/015886

(56) Entgegenhaltungen:
- WO-A1-2006/076248
- US-A- 4 144 139
- US-A- 5 011 565
- US-A- 5 543 333
- METTE A ET AL: "Increasing the Efficiency of Screen-Printed Silicon Solar Cells by Light-Induced Silver Plating" PHOTOVOLTAIC ENERGY CONVERSION, CONFERENCE RECORD OF THE 2006 IEEE 4TH WORLD CONFERENCE ON, IEEE, PI, 1. Mai 2006 (2006-05-01), Seiten 1056-1059, XP031007489 ISBN: 978-1-4244-0016-4

## Beschreibung

### Anwendungsgebiet und Stand der Technik

Die Erfindung betrifft ein Verfahren zur Beschichtung einer Solarzelle bzw. einer Oberfläche davon mit Metall sowie eine Vorrichtung zur Durchführung des Verfahrens.

Es ist verschiedentlich bekannt, lichtinduziert Metall auf Siliziumsubstrate bzw. Solarzellen nasschemisch abzuscheiden, siehe beispielsweise DE 43 11 173 A1, US 5.011.565, US 5.543.333, US 4.144.139, WO 2006/076248 A1 und den Zeitschriftenaufsatz A. Mette et al., Increasing the Efficiency of Screen-Printed Silicon Solar Cells by Light-Induced Silver Plating, Photov. Energy Conv. Conf. Rec. of the 2006 IEEE 4th World Conf., IEEE, PI, 01.05.2006, S.1056. Im Fall der Solarzelle wird diese durch die Lichteinstrahlung halbleitend und kann somit als Kathode in einem galvanischen Stromkreis zur Metallabscheidung genutzt werden. Das Licht wird durch Leuchtmittel wie beispielsweise Glühlampen erzeugt, alternativ auch durch UV-Lampen oder IR-Lampen oder LED. Zur Erzeugung eines ausreichend großen Galvanisierungsstroms an den Solarzellen wird eine hohe Lichtintensität benötigt, was aufwändig ist und auch zu einer ungewollten Aufheizung des Beschichtungsbades führen kann. Dann ist eine aufwändige Kühlung nötig. Aus dem erwähnten Stand der Technik ist es bekannt, bei Bedarf die Wellenlänge des eingestrahlten Lichts auf das Transmissionsvermögen des Beschichtungsbades abzustimmen, um die Baderwärmung gering zu halten. Beim Stand der Technik gemäß den obigen Druckschriften sind die Lichtquellen typischerweise in einem gewissen Abstand zum zu beschichtenden Substrat außerhalb des Beschichtungsbades angeordnet.

### Aufgabe und Lösung

Der Erfindung liegt die Aufgabe zugrunde, ein eingangs genanntes Verfahren sowie eine entsprechende Vorrichtung zur Durchführung des Verfahrens zu schaffen, mit denen Probleme des Standes der Technik vermieden werden können und insbesondere eine effiziente lichtinduzierte oder lichtunterstützte Beschichtung durchgeführt werden kann bei geringem Aufwand.

Gelöst wird diese Aufgabe durch ein Verfahren mit den Merkmalen des Anspruchs 1 sowie eine Vorrichtung mit den Merkmalen des Anspruchs 9. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass an der Oberfläche der Solarzelle bzw. an der Solarzelle beispielsweise Elektrodenstrukturen erzeugt werden. Dabei sind die Elektrodenstrukturen bereits leitfähig vorhanden, sie werden entweder metallisch verstärkt oder vollständig aufgebaut. Aufgebaut werden können sie auf sogenannten Seed-Schichten oder metallisch verstärkt auf Siebdruckpasten. Die Solarzelle ist dabei mit einem Beschichtungsbad benetzt, vorteilhaft darin eingetaucht. Licht wird von mehreren Lichtquellen in das Beschichtungsbad eingestrahlt zur lichtinduzierten bzw. lichtunterstützten Beschichtung der Oberfläche der Solarzelle in dem Beschichtungsbad durch Erzeugen von Spannung und Strom in der Solarzelle aufgrund der Lichteinstrahlung.

Erfingdungsgemäß sind eine oder mehrere der Lichtquellen samt Halterung und dergleichen in dem Beschichtungsbad angeordnet und/oder reichen in das Beschichtungsbad hinein. Im ersten Fall sind beide Teile, ebenso wie außerhalb angeordnete Lichtquellen, austauschbar, ohne in das Beschichtungsbad bzw. die Dichtheit einer Beschichtungswanne mit dem Beschichtungsbad darin eingreifen zu müssen. Dies vereinfacht nicht nur den Aufbau, sondern stellt auch einen störungsfreien Betrieb sicher. Durch diese Anordnung können die betreffenden Lichtquellen durch das Beschichtungsbad selber gekühlt werden.

Die Lichtquellen sind zweckmäßig so ausgebildet bzw. strahlen großteils derart in einem Lichtwellenlängenbereich ab, dass die Wellenlänge bzw. ihre Farbe derjenigen des Beschichtungsbades entspricht. Des Weiteren können die Lichtquellen großflächig angeordnet bzw. ausgebildet sein, insbesondere bei zahlreichen Lichtquellen in ihrer Gesamtheit, so dass sie im wesentlichen die gesamte Fläche der Solarzelle beleuchten. So kann bewirkt werden, dass die Transmission des flächig strahlenden Lichts durch das Beschichtungsbad hindurch möglichst groß ist und Verluste möglichst gering sind. Dadurch wird erreicht, dass mit geringeren Leistungen an den Lichtquellen gearbeitet werden kann, was Energie spart und es möglich macht, diese kleiner zu dimensionieren. Des Weiteren wird das Problem der Erwärmung des Beschichtungsbades durch die mit weniger Leistung strahlenden Lichtquellen reduziert. Hauptsächlich aber wird dabei erreicht, dass mehr bzw. maximal viel von dem ausgestrahlten Licht an die Solarzelle bzw. ihre Oberfläche gelangt und somit der großflächige Beschichtungsvorgang maximal gut unterstützt wird bzw. abläuft. Schließlich ist auch die Verlustwärme im Beschichtungsbad durch die hindurchgehende Lichtstrahlung sehr viel geringer, so dass auch diesbezüglich eine Erwärmung des Beschichtungsbades reduziert oder sogar ganz vermieden wird.

Die großflächige Bestrahlung mit Licht bewirkt bei der Solarzelle eine Aktivierung für eine gute großflächige Abscheidung des Metalls. Diese Abscheidung erfolgt vorteilhaft galvanisch und ist besonders vorteilhaft eine sogenannte ungerichtete Abscheidung. Gerade wegen dieser ungerichteten großflächigen Abscheidung ist die großflächige Bestrahlung wichtig, und dafür wiederum die großflächige Lichtleistung bei gleichzeitiger möglichst geringer Erwärmung des Beschichtungsbades im Gegensatz zu gerichteten, kleinflächigen Lichtquellen wie Laserstrahlen odgl.. Bevorzugt wird das Verfahren mit einer horizontalen Durchlaufanlage durchgeführt.

Es wird als vorteilhaft angesehen, wenn mindestens 80%, besonders vorteilhaft sogar mindestens 90%, der Lichtenergie der Lichtquellen in einem Lichtwellenlängenbereich sind, der höchstens 5% von der maximalen Transmissionswellenlänge des Beschichtungsbades entfernt ist. Dies bedeutet also, dass ein möglichst großer Teil des Lichts von der Farbe bzw. der Wellenlänge her möglichst genau dem Beschichtungsbad angepasst sein sollte.

Bevorzugt wird die Solarzelle in dem Beschichtungsbad mit einem Metall beschichtet, das aus der Gruppe von Silber, Kupfer, Nickel oder Zinn ausgewählt ist. Weist das Beschichtungsbad beispielsweise Kupfer auf bzw. soll darin die Solarzelle großflächig mit Kupfer beschichtet werden, so ist das Beschichtungsbad blau. Dementsprechend strahlen die Lichtquellen blaues Licht ab, insbesondere ausschließlich blaues Licht. Vor allem aber wird vorteilhaft die genaue Wellenlänge des blauen Lichts genau auf diejenige des blauen Beschichtungsbades abgestimmt, wie vorstehend erläutert worden ist.

In alternativer Ausgestaltung der Erfindung kann bei großflächiger Beschichtung mit Nickel ein entsprechend grün gefärbtes Beschichtungsbad vorgesehen sein. Dann strahlen die Lichtquellen erfindungsgemäß grünes Licht ab, insbesondere wiederum möglichst genau abgestimmt auf den maximalen Transmissionswellenlängenbereich des grünen Beschichtungsbades.

Beschichtungsbäder für Silber sind üblicherweise milchig transparent. Auch hier können die Lichtquellen entsprechend möglichst gut abgestimmt werden, indem rotes Licht großflächig ausgestrahlt wird.

Gemäß einer grundsätzlichen Ausgestaltung der Erfindung ist es möglich, die Lichtquellen unverändert zu lassen zur Anpassung an unterschiedliche Beschichtungsbäder. Dann können zur Änderung der Farbe unterschiedliche Farbfilter an den Lichtquellen montiert werden. Dies bedeutet, dass die Lichtquellen weiterhin sehr viel mehr Licht erzeugen müssen als durch das Beschichtungsbad hindurch bei der Solarzelle ankommt. Es kann aber dann wenigstens eine Erwärmung des Beschichtungsbades vermieden werden.

In alternativer grundsätzlicher Ausgestaltung der Erfindung können die Lichtquellen ganz ausgetauscht werden, um sie an unterschiedliche Beschichtungsbäder bzw. die Farbe der Beschichtungsbäder anzupassen. Dies bedeutet aber einen im Vergleich zu dem Austausch von Farbfiltern odgl. erhöhten Aufwand. Gleichzeitig kann jedoch mit beiden Ausgestaltungen an einer Beschichtungsanlage bzw. einer erfindungsgemäßen Vorrichtung eine großflächige Beschichtung mit unterschiedlichen Metallen erfolgen.

In nochmals weiterer grundsätzlicher Ausgestaltung der Erfindung kann auch vorgesehen werden, dass eine Beschichtungsanlage genau für ein Beschichtungsbad ausgelegt ist, so dass weder Farbfilter noch die Lichtquellen an sich ausgetauscht werden müssen, sondern unverändert bleiben können.

In Ausbildung der Erfindung ist es möglich, die Lichtquellen zu kühlen. Dies bietet sich vor allem bei Glühlampen an. Alternative Lichtquellen wie LED können vorteilhaft auch gekühlt werden, vor allem dann, wenn hohe Beleuchtungsstärken gewählt werden. Ihre Wärmeentwicklung ist dann so groß, dass eine Kühlung vorteilhaft ist. Der Kühlaufwand ist aber immer noch deutlich geringer als bei Glühlampen. Nicht nur deswegen, sondern auch allgemein werden LED als Lichtquellen bevorzugt. Der Grund liegt hierfür in dem relativ geringen Stromverbrauch bzw. in der sehr guten Lichtausbeute im Vergleich zur benötigten Energie bzw. Lichtstrom pro Leistung. Ebenso weisen sie ein günstiges Preis-Leistungsverhältnis auf. LED können auch, beispielsweise als OLED, heutzutage mit relativ großer Lichtleistung und vielfältigen Farben hergestellt werden. Des Weiteren weisen sie, im Unterschied zu üblichen Glühlampen, nicht nur den Vorteil erheblich geringerer Wärmeabstrahlung auf, sondern auch eine erheblich höhere Lebensdauer. Dadurch ist ein Austausch erheblich seltener notwendig, was bei Vorrichtungen für derartige Beschichtungsbäder mit Dichtheitsproblemen ein großer Vorteil ist.

Zur Kühlung kann neben einer Kühlung direkt durch das Beschichtungsbad eine externe Kühlung vorgesehen sein. Diese kann in Halter odgl. für LED integriert sein und dann ein Kühlmittel oder Kühlwasser aus dem Beschichtungsbad heraus führen, wo es wieder gekühlt wird. Als weiterer, unter Umständen auch eigenständiger Erfindungsaspekt kann eine Lichtquelle so ausgebildet sein, dass auf einem Träger oder einer Platine eine Vielzahl von LED montiert und elektrisch angeschlossen sind. Sie können einen Abstand von wenigen Millimetern aufweisen und vorteilhaft in gerader Linie mit gleicher Abstrahlrichtung angeordnet sein. An der Leiterplatte oder Platine ist ein vorzugsweise fremdgekühlter Kühlkörper vorgesehen, vorteilhaft in möglichst gut wärmeleitendem Kontakt. Dieser Kühlkörper wird von außerhalb des Beschichtungsbades mit Kühlmittel gekühlt, vorteilhaft mit Wasser. Diese Kombination aus Träger mit LED und Kühlkörper wird dann in einen Mantel aus möglichst gut lichtdurchlässigem Material, beispielsweise Glas bzw. Quarzglas, angeordnet und ist so abgedichtet zum Absenken in das Beschichtungsbad. Innerhalb des Beschichtungsbades sind vorteilhaft die elektrischen Anschlüsse sowie Kühlleitungen nach außen geführt. Für das Material des Zylinders ist zu beachten, dass es insbesondere auch für die gewählte Wellenlänge des Lichts eine möglichst hohe Lichtdurchlässigkeit aufweist.

In weiterer vorteilhafter Ausgestaltung der Erfindung sind die Lichtquellen im Betrieb starr bzw. unbeweglich, werden also während der Lichterzeugung nicht bewegt. Ähnliches gilt auch für weitere optische Einrichtungen, die zur Übertragung des Lichts in großflächiger Art und Weise in das Beschichtungsbad hinein und auf die Oberfläche der Solarzelle dienen. In der Regel ist dies wegen der großflächigen Ausbildung bzw. Anordnung der Lichtquellen und der daraus resultierenden großflächigen Bestrahlung der Solarzellen auch nicht günstig.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

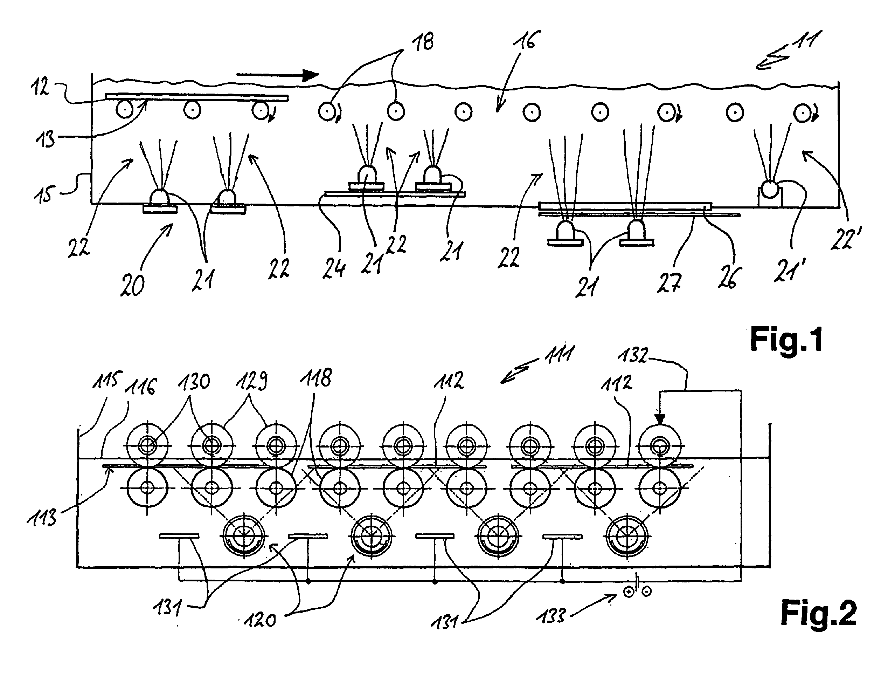

Ausführungsbeispiele der Erfindung sind in den Zeichnungen schematisch dargestellt und werden im Folgenden näher erläutert. In den Zeichnungen zeigt die Fig. 1 eine sehr schematische seitliche Schnittdarstellung durch eine erfindungsgemäße Beschichtungsvorrichtung mit unterschiedlichen möglichen Anordnungen von Lichtquellen mit jeweils angepasster Lichtwellenlänge. Die Fig. 2 zeigt eine Beschichtungsvorrichtung ähnlich Fig. 1 gemäß der Erfindung mit mehreren Lichtquellen darin und vor allem Elektrodenanordnungen.

### Detaillierte Beschreibung der Ausführungsbeispiele

Die Fig. 1 zeigt eine erfindungsgemäße Beschichtungsvorrichtung 11 in stark vereinfachter Darstellung. In ihr werden Solarzellen 12 aus Silizium zur Herstellung von fertigen Solarzellen zumindest an ihrer Unterseite 13 beschichtet. Dazu läuft die Solarzelle 12 auf Transportrollen 18 durch eine Beschichtungswanne 15, welche ein Beschichtungsbad 16 enthält. Das Beschichtungsbad 16 kann unterschiedliche Metalle enthalten zur Abscheidung auf die Solarzellen 12 bzw. zu dessen Beschichtung. Beispielsweise ist es vorgenanntes Kupfer oder Nickel.

An der Unterseite des Beschichtungsbades 16 bzw. der Beschichtungswanne 15 sind unterschiedliche Arten von Lichtquellen 20 angeordnet. Ganz links sind als Lichtquellen 20 zwei LED 21 dargestellt. Diese sind von außen durch entsprechende Durchbrüche in der Beschichtungswanne 15 in das Innere hindurch gesteckt und strahlen Licht 22 von unten an die Unterseite 13 der Solarzellen 12. Mehrere dieser LED 21 sind vorteilhaft in Reihen parallel zu den Transportrollen 18 vorgesehen, also quer zur Transportrichtung der Solarzellen 12. Sie könnten auch an der Seite angeordnet sein. Durch die Befestigung der LED 21 von außen können sie entnommen werden, beispielsweise zum Austausch oder zur Reparatur. Dazu ist jedoch das Beschichtungsbad 16 abzulassen.

Enthält das Beschichtungsbad 16 Kupfer zur Beschichtung der Solarzelle 12 mit Kupfer, so weist es blaue Farbe auf. Dementsprechend ist das Licht 22 der LED 21 blau und weist möglichst genau den Blauton des Beschichtungsbades 16 auf bzw. einen Lichtwellenlängenbereich, der genau dem maximalen Transmissionswellenlängenbereich des Beschichtungsbades 16 entspricht.

Weitere Lichtquellen 20 weisen als Alternative zwar ebenfalls LED 21 auf. Diese LED 21 sind jedoch, wie in der Mitte dargestellt ist, an einem Träger 24 befestigt. Dieser Träger 24 befindet sich samt der LED 21 innerhalb des Beschichtungsbades 16. Zum Austausch der LED 21 kann der gesamte Träger 24 aus der Beschichtungswanne 15 entnommen werden, ohne das Beschichtungsbad 16 ablassen zu müssen. Des weiteren werden die LED 21 oder sonstige Lichtquellen dadurch bei Bedarf möglichst stark gekühlt. Auch hier sind die LED 21 vorteilhaft in die Zeichenebene hinein parallel zu den Transportrollen 18 in Reihen angeordnet. Auch diese LED 21 weisen einen Lichtwellenlängenbereich des abgestrahlten Lichts 22 auf wie vorbeschrieben.

In nochmals weiterer Ausgestaltung ist rechts am Boden der Beschichtungswanne 15 ein Fenster 26 vorgesehen, beispielsweise aus Glas. LED 21 als Lichtquellen 20 sind dahinter angeordnet und strahlen durch das Fenster 26 das Licht 22 nach oben an die Unterseiten 13 der Solarzellen 12. Auch dieses Licht weist die gleiche Wellenlänge auf wie vorbeschrieben. Des weiteren ist hier als Option noch ein Farbfilter 27 zwischen den LED 21 und dem Fenster 26 bzw. dem Beschichtungsbad 16 angeordnet. Falls die hinter dem Fenster 26 angeordneten LED 21 kein bestimmtes, auf das Beschichtungsbad 16 abgestimmtes Licht ausstrahlen, sondern beispielsweise lediglich weißes Licht, kann es durch den Farbfilter 27 in entsprechend blaues Licht geändert werden für ein Beschichtungsbad mit Kupfer oder eben grünes Licht für ein Beschichtungsbad mit Nickel. Dabei geht zwar ein Großteil der Lichtenergie verloren. Es wird jedoch erreicht, dass lediglich entsprechend blaues oder grünes Licht mit genau der gewünschten Lichtwellenlänge in das Beschichtungsbad 16 eingestrahlt wird und zumindest in dem Bad möglichst wenig Erwärmung durch Lichtabsorption bewirkt. Zur Anpassung an unterschiedlich farbige Beschichtungsbäder 16 kann ein Farbfilter 27 mit relativ wenig Aufwand ausgetauscht werden. Alternativ können natürlich ein Farbfilter 27 weggelassen und farbige LED 21 je nach Bedarf bzw. nach benötigter Lichtwellenlänge hinter dem Fenster 26 angeordnet werden.

Schließlich ist in Figur 1 noch ganz rechts als Lichtquellen 20 eine Neonröhre 21' dargestellt. Auch diese ist vollständig innerhalb der Beschichtungswanne 25 und somit innerhalb des Beschichtungsbades 16 angeordnet, was jedoch keineswegs so sein müsste. Auch sie strahlt ihr Licht 22' mit entsprechender Lichtwellenlänge an die Unterseite 13 der Solarzellen 12. Für eine derartige Neonröhre 21' als Ersatz für eine Reihe von LED 21 gilt bezüglich Lichtwellenlänge, Anordnung oder Farbfilter odgl. dasselbe.

Zusätzlich zu der lichtinduzierten oder lichtunterstützten Beschichtung kann auch eine Stromunterstützung vorgesehen sein wie bei einer üblichen elektrochemischen Beschichtung. Je nach Beschichtungsverfahren kann auch mit wechselnder Stromunterstützung oder Lichtunterstützung gearbeitet werden.

In Fig. 2 ist eine Beschichtungsvorrichtung 111 dargestellt als Abwandlung derjenigen aus Fig. 1 bzw. als etwas präzisere Ausgestaltung. In einer Beschichtungswanne 115 mit einem Beschichtungsbad 116 darin laufen wiederum die Solarzellen 112 mit der Unterseite 113 nach unten und werden von Transporträdern 118 transportiert. Unter den Transporträdern 118 sind versetzt dazu längliche Lichtquellen 120 angeordnet. Diese können gemäß einer der vorstehend beschriebenen Möglichkeiten ausgebildet sein. Sie strahlen nach oben auf die Unterseite 113 der Solarzellen 112.

Zur Galvanisierung bzw. Beschichtung der Solarzellen 112 werden sie von oben mit Kontakträdern 129 auf Wellen 130 elektrisch kontaktiert durch elektrisch leitendes Anliegen an der Rückseite. Dadurch wird eine Kathode im von außen angelegten Galvanikstrom bereitgestellt. Anstelle der in Fig. 2 dargestellten Kontaktierräder 129 können natürlich alternative elektrische Kontaktierungen an eine Solarzelle 112 vorgesehen sein.

Zwischen den Lichtquellen 120 sind vier Anoden 131 vorgesehen für die Anodenfunktion im Beschichtungsbad 116. Die Anoden sollten sich in etwa über die Breite der Beschichtungswanne 115 erstrecken. Sowohl die als Kathoden arbeitenden Kontaktierräder 129 als auch die Anoden 131 sind über eine Leiteranordnung 132 mit einer Stromquelle 133 verbunden für den Galvanikstrom, der so an die Solarzellen 12 angelegt wird. Die Anoden 131 sind vorteilhaft unlöslich ausgebildet und können, ähnlich wie auch die Kontaktierräder 129, beispielsweise gemäß der DE 102 005 038 450 A1 ausgebildet sein.

Die Lichtquellen 120 können so lang sein, dass sie mit mindestens einem Ende, eventuell auch mit beiden, an beiden Seiten aus dem Beschichtungsbad 115 herausragen und somit dichtend in dessen Wandung befestigt sind. Dadurch wird eine leichte Austauschbarkeit und Befestigung erreicht. Insbesondere ist es beispielsweise auch möglich, dass zum Austausch der darin befindlichen LED die Glasrohre an der Beschichtungswanne 115 verbleiben und die LED samt einem Träger herausgezogen werden, was zum einen leicht durchführbar ist zum anderen die Dichtung gewährleistet.

Durch die Lichteinstrahlung wird der Halbleiter der Solarzelle leitfähig gemacht für eine anschließende Galvanisierung bzw. Beschichtung. Dabei ist die Solarzelle in dem Galvanikstromkreis die Kathode, wozu hier die Stromquelle samt den oberen Kontakträdern vorgesehen ist. Die Anode im Galvanikstromkreis ist eben die separat darunter angeordnete Anode. Vorteilhaft ist auch der Abstand zwischen Solarzelle und Lichtquelle möglichst gering für eine möglichst effektive Lichtausbeute der Lichtquelle an der Solarzelle.

Die Fig. 1 zeigt zur Vereinfachung der Darstellung keine externe Gleichrichterbeschaltung und keine Elektroden für eine Elektrolyse, um hier die verschiedenen Anordnungsmöglichkeiten der Lichtquellen besser zu zeigen. Prinzipiell aber kann eine Elektrolyse auch wie dort dargestellt ablaufen, also ohne Elektroden, wenn die Rückseite der Solarzelle mit einem Metall beschichtet ist, das sich wie eine unlösliche Anode verhält. Die Lichteinstrahlung mittels Leuchtmittel generiert eine Spannung an der Zelle, die einen Zellstrom bzw. Elektrolyse in Gang bringt. Dieser Zellstrom initiiert eine Metallabscheidung aus dem entsprechend zusammengesetzten Beschichtungsbad auf die Vorderseite der Solarzelle. Wird die Rückseite jedoch mit Aluminium bedruckt, was überwiegend für Solarzellen-Massenproduktion gemacht wird, kann ohne die externe Beschaltung eines Gleichrichters als Spannungsquelle 133 und ohne die Elektroden 129 und 131 gemäss Fig. 2 nicht prozessiert werden, da sich Aluminium löslich verhält.

Vorteilhaft möglich ist auch eine Puls-Abscheidung gemäß beispielsweise der DE 4225961 A1, die üblicherweise durch den Gleichrichter gesteuert bzw. geregelt wird. Dies kann aber auch allgemein gerade bei Anwendung von LED vorteilhaft über das Licht erfolgen. Wird das Licht zur Puls-Abscheidung verwendet, so hat dies den Vorteil, dass sich die Rückseite der Zelle nicht auflöst, wenn die Solarzelle durch die Lichtabschaltung sperrt. Die Rückseiten von Solarzellen sind oft mit Metallen beschichtet, die sich anodisch auflösen, z.B. Aluminium. Die Lichtabschaltung unterbricht den Elektrolyse-Zellstrom während der Puls-Pause. Die Gleichrichterabschaltung zur Erzeugung der Puls-Pause ist ohne Wirkung, da die Solarzelle bei gleichzeitiger Beleuchtung in der Gleichrichterpause den Zellstrom selbst liefern würde und die Elektrolyse nicht gepulst ablaufen könnte.

## Patentansprüche

1. Verfahren zur Beschichtung einer Oberfläche (13, 113) einer Solarzelle (12, 112) mit einem Metall, insbesondere zur Erzeugung von Elektrodenstrukturen, wobei die Solarzelle (12, 112) in ein das Metall enthaltende Beschichtungsbad (16, 116) eingetaucht wird und ihre zu beschichtende Oberfläche im Wesentlichen ganzflächig mit Licht (22, 122) bestrahlt wird, das von mehreren Lichtquellen (20, 21, 120) in das Beschichtungsbad (16, 116) zur lichtinduzierten oder lichtunterstützten Beschichtung der Oberfläche (13, 113) in dem Beschichtungsbad eingestrahlt wird, wobei die Lichtquellen (20, 21, 120) im Wesentlichen in einem Lichtwellenlängenbereich strahlen, der zur Minimierung von Lichtabsorption durch das Beschichtungsbad auf einen Transmissionswellenlängenbereich des Beschichtungsbades (16, 116) abgestimmt ist, **dadurch gekennzeichnet, dass** die Lichtquellen (20, 21, 120) eine oder mehrere Lichtquellen umfassen, die in das Beschichtungsbad selber hineinreichen und/oder samt einer zugehörigen Halterung (24) in dem Beschichtungsbad (16, 116) angeordnet sind.

2. Verfahren nach Anspruch 1, **dadurch gekennzeichnet, dass** mindestens 80%, vorzugsweise mindestens 90%, der Lichtenergie der Lichtquellen (20, 21, 120) eine Wellenlänge aufweist, die maximal 5% von einer maximalen Transmissionswellenlänge des Beschichtungsbades (16, 116) entfernt liegt.

3. Verfahren nach Anspruch 1 oder 2, **dadurch gekennzeichnet, dass** die Oberfläche (13, 113) der Solarzelle (12, 112) mit einem Metall aus der Gruppe Silber, Kupfer, Nickel, Zinn beschichtet wird.

4. Verfahren nach Anspruch 3, **dadurch gekennzeichnet, dass** das Beschichtungsbad (16, 116) Kupfer als das Metall aufweist und von blauer Farbe ist und die Oberfläche (13, 113) mit Kupfer beschichtet wird, wobei die Lichtquellen (20, 21, 120) entsprechend blaues Licht (22, 122) abstrahlen, insbesondere ausschließlich blaues Licht.

5. Verfahren nach Anspruch 3, **dadurch gekennzeichnet, dass** das Beschichtungsbad (16, 116) Nickel als das Metall aufweist und von grüner Farbe ist und die Halbleiteroberfläche (13, 113) mit Nickel beschichtet wird, wobei die Lichtquellen (20, 21, 120) entsprechend grünes Licht (22, 122) abstrahlen, insbesondere ausschließlich grünes Licht.

6. Verfahren nach einem der Ansprüche 1 bis 3, **dadurch gekennzeichnet, dass** zur Anpassung an unterschiedliche Beschichtungsbäder (16, 116) bzw. deren Farbe unterschiedliche Farbfilter (27) an die Lichtquellen (20, 21, 120) montiert werden.

7. Verfahren nach einem der Ansprüche 1 bis 3, **dadurch gekennzeichnet, dass** die Lichtquellen (20, 21, 120) zur Anpassung an unterschiedliche Beschichtungsbäder (16, 116) bzw. deren Farbe ausgetauscht werden.

8. Verfahren nach einem der vorhergehenden Ansprüche, **dadurch gekennzeichnet, dass** die Lichtquellen (20, 21, 120) gekühlt werden, vorzugsweise durch das Beschichtungsbad (16, 116) oder einen nach außen geführten Kühlwasserkreislauf.

9. Vorrichtung zur Durchführung des Verfahrens nach einem der vorhergehenden Ansprüche, mit
- einem in einer Beschichtungswanne (15) enthaltenen Beschichtungsbad (16),
- Mitteln (18, 118) zum Transport der Solarzelle im Wesentlichen horizontal durch das Beschichtungsbad in der Beschichtungswanne hindurch und
- einer Mehrzahl von Lichtquellen (20, 21, 120) zum im Wesentlichen ganzflächigen Bestrahlen der dadurch lichtinduziert oder lichtunterstützt zu beschichtenden Solarzellenoberfläche in dem Beschichtungsbad, wobei die Lichtquellen im Wesentlichen in einem Lichtwellenlängenbereich strahlen, der zur Minimierung von Lichtabsorption durch das Beschichtungsbad auf einen Transmissionswellenlängenbereich des Beschichtungsbades abgestimmt ist und wobei die Lichtquellen eine oder mehrere Lichtquellen umfassen, die in das Beschichtungsbad selber hineinreichen und/oder samt einer zugehörigen Halterung (24) in dem Beschichtungsbad angeordnet sind.

10. Vorrichtung nach Anspruch 9, **dadurch gekennzeichnet, dass** die Lichtquellen LED (21) sind, insbesondere OLED.

11. Vorrichtung nach Anspruch 9 oder 10, **dadurch gekennzeichnet, dass** eine wärmeleitende Kopplung zwischen Beschichtungsbad (16, 116) und Lichtquellen (20, 21, 120) vorgesehen ist.

12. Vorrichtung nach Anspruch 9 oder 10, **dadurch gekennzeichnet, dass** sie einen nach außen geführten Kühlwasserkreislauf aufweist zur Kühlung der Lichtquellen (20, 21, 120) unabhängig vom Beschichtungsbad (16, 116).

13. Vorrichtung nach einem der Ansprüche 9 bis 12, **dadurch gekennzeichnet, dass** die Lichtquellen (20, 21, 120) über das Beschichtungsbad (16, 116) verteilt angeordnet sind.

14. Vorrichtung nach einem der Ansprüche 9 bis 13, **dadurch gekennzeichnet, dass** die Lichtquellen (20, 21, 120) austauschbar sind ohne Eingriff in das Beschichtungsbad (16, 116) bzw. in die Dichtheit der das Beschichtungsbad (16, 116) aufnehmenden Beschichtungswanne (15, 115).

15. Vorrichtung nach einem der Ansprüche 9 bis 13, **dadurch gekennzeichnet, dass** die Lichtquellen (20, 21, 120) mit einem austauschbaren Farbfilter (27) versehen sind zur Anpassung der Wellenlänge der Farbe des abgestrahlten Lichts (22, 122) an diejenige des Beschichtungsbades (16, 116).

## Claims

1. A method for coating a surface (13, 113) of a solar cell (12, 112) using a metal, in particular for producing electrode structures, wherein the solar cell (12, 112) is dipped into a coating bath (16, 116) including the metal and light (22, 122) is irradiated essentially onto the full surface of the cell surface to be coated, said light being irradiated by multiple light sources (20, 21, 120) into the coating bath (16, 116) for light-induced or light-assisted coating of the surface (13, 113) in the coating bath, wherein the light sources (20, 21, 120) are emitting essentially in a range of light wavelengths adjusted to a transmission wavelength range of the coating bath (16, 116) to minimize light absorption by the coating bath, **characterized in that** the light sources (20, 21, 120) comprise one or more light sources reaching into the coating bath itself and/or disposed in the coating bath (16, 116) together with a respective attachment (24).

2. The method according to claim 1, **characterized in that** at least 80 %, preferably at least 90 %, of the light energy of the light sources (20, 21, 120) have a wavelength differing at maximum 5 % from a maximum transmission wavelength of the coating bath (16, 116).

3. The method according to claim 1 or 2, **characterized in that** the surface (13, 113) of the solar cell (12, 112) is coated using a metal from the group of silver, copper, nickel, tin.

4. The method according to claim 3, **characterized in that** the coating bath (16, 116) includes copper as the metal and has a blue colour, and the surface (13, 113) is coated by copper, wherein the light sources (20, 21, 120) correspondingly emit blue light (22, 122), in particular exclusively blue light.

5. The method according to claim 3, **characterized in that** the coating bath (16, 116) includes nickel as the metal and has a green colour, and the semiconductor surface (13, 113) is coated by nickel, wherein the light sources (20, 21, 120) correspondingly emit green light (22, 122), in particular exclusively green light.

6. The method according to any of the claims 1 to 3, **characterized in that** for adapting to different coating baths (16, 116) or the colour thereof, different colour filters (27) are mounted to the light sources (20, 21, 120).

7. The method according to any of the claims 1 to 3, **characterized in that** for adapting to different coating baths (16, 116) or the colour thereof, the light sources (20, 21, 120) are exchanged.

8. The method according to any of the preceding claims, **characterized in that** the light sources (20, 21, 120) are cooled, preferably by the coating bath (16, 116) or a cooling water cycle with external connection.

9. A device for operating the method according to any of the preceding claims, comprising
- a coating bath (16) contained in a coating vat (15),
- means (18, 118) for conveying the solar cell essentially in a horizontal position through the coating bath in the coating vat, and
- a multitude of light sources (20, 21, 120) for essentially full surface irradiation of the solar cell surface to be coated in a light-induced or light-assisted manner in the coating bath, wherein the light sources are emitting essentially in a range of light wavelengths adjusted to a transmission wavelength range of the coating bath to minimize light absorption by the coating bath, and wherein the light sources comprise one or more light sources reaching into the coating bath itself and/or disposed in the coating bath together with a respective attachment (24).

10. The device according to claim 9, **characterized in that** the light sources are LEDs (21), in particular OLEDs.

11. The device according to claim 9 or 10, **characterized in that** a thermoconducting coupling between the coating bath (16, 116) and the light sources (20, 21, 120) is provided.

12. The device according to claim 9 or 10, **characterized in that** a cooling water cycle with external connection is provided for cooling the light sources (20, 21, 120) independent of the coating bath (16, 116).

13. The device according to any of the claims 9 to 12, **characterized in that** the light sources (20, 21, 120) are arranged distributed over the coating bath (16, 116).

14. The device according to any of the claims 9 to 13, **characterized in that** the light sources (20, 21, 120) are exchangeable without intervention in the coating bath (16, 116) or the leak tightness of the coating vat (15, 115) holding the coating bath (16, 116).

15. The device according to any of the claims 9 to 13, **characterized in that** the light sources (20, 21, 120) are provided with an exchangeable colour filter (27) for adapting the wavelength of the colour of the emitted light (22, 122) to that of the coating bath (16, 116).

## Revendications

1. Procédé de revêtement d'une surface (13, 113) d'une cellule solaire (12, 112) par un métal, en particulier pour former des structures d'électrodes,
la cellule solaire (12, 112) étant immergée dans un bain de revêtement (16, 116) contenant le métal et essentiellement la totalité de sa surface à revêtir étant irradiée par de la lumière (22, 122) projetée par plusieurs sources de lumière (20, 21, 120) dans le bain de revêtement (16, 116) pour revêtir la surface (13, 113) présente dans le bain de revêtement sous l'induction de la lumière ou avec l'assistance de la lumière,
les sources de lumière (20, 21, 120) irradiant essentiellement dans une plage de longueurs d'ondes lumineuses qui est ajustée à une plage de longueurs d'ondes transmises par le bain de revêtement (16, 116) en vue de minimiser l'absorption de lumière par le bain de revêtement, **caractérisé en ce que**
les sources de lumière (20, 21, 120) comportent une ou plusieurs sources de lumière qui s'enfoncent dans le bain de revêtement proprement dit et/ou qui sont disposées dans le bain de revêtement (16, 116) en même temps qu'un support (24) qui leur est associé.

2. Procédé selon la revendication 1, **caractérisé en ce qu'**au moins 80 % et de préférence au moins 90 % de l'énergie lumineuse des sources de lumière (20, 21, 120) présentent une longueur d'onde située à au plus 5 % d'une longueur d'onde à laquelle le bain de revêtement (16, 116) présente une transmission maximale.

3. Procédé selon les revendications 1 ou 2, **caractérisé en ce que** la surface (13, 113) de la cellule solaire (12, 112) est revêtue d'un métal du groupe constitué de l'argent, du cuivre, du nickel et du zinc.

4. Procédé selon la revendication 3, **caractérisé en ce que** le bain de revêtement (16, 116) présente du cuivre comme métal et est de couleur bleue et **en ce que** la surface (13, 113) est revêtue du cuivre, les sources lumineuses (20, 21, 120) émettant une lumière bleue (22, 122) correspondante et en particulier exclusivement de la lumière bleue.

5. Procédé selon la revendication 3, **caractérisé en ce que** le bain de revêtement (16, 116) présente du nickel comme métal et est de couleur verte et **en ce que** la surface (13, 113) du semi-conducteur est revêtue de nickel, les sources de lumière (20, 21, 120) émettant de la lumière verte (22, 122) correspondante et en particulier exclusivement de la lumière verte.

6. procédé selon l'une des revendications 1 à 3, **caractérisé en ce que** différents filtres colorés (27) sont montés sur les sources de lumière (20, 21, 120) pour permettre une adaptation à différents bains de revêtement (16, 116) ou à leur couleur.

7. Procédé selon l'une des revendications 1 à 3, **caractérisé en ce que** les sources de lumière (20, 21, 120) sont changées pour permettre leur adaptation à différents bains de revêtement (16, 116) ou à leur couleur.

8. Procédé selon l'une des revendications précédentes, **caractérisé en ce que** les sources de lumière (20, 21, 120) sont refroidies, de préférence par le bain de revêtement (16, 116) ou par un circuit extérieur d'eau de refroidissement.

9. Dispositif en vue de la mise en oeuvre du procédé selon l'une des revendications précédentes, le dispositif présentant :
un bain de revêtement (16) repris dans une cuve de revêtement (15),
des moyens (18, 118) permettant le transport de la cellule solaire en position essentiellement horizontale dans le bain de revêtement présent dans la cuve de revêtement et
plusieurs sources de lumière (20, 21, 120) qui irradient essentiellement la totalité de la surface à revêtir des cellules solaires placées dans le bain de revêtement, sous l'induction de la lumière ou avec l'assistance de la lumière, les sources de lumière irradiant essentiellement dans une plage de longueurs d'ondes lumineuses qui est ajustée à une plage de longueurs d'ondes transmises par le bain de revêtement en vue de minimiser l'absorption de lumière par le bain de revêtement et les sources de lumière comportant une ou plusieurs sources de lumière qui s'enfoncent dans le bain de revêtement proprement dit et/ou qui sont disposées dans le bain de revêtement en même temps qu'un support (24) qui leur est associé.

10. Dispositif selon la revendication 9, **caractérisé en ce que** les sources de lumière sont des LED (21) et en particulier des OLED.

11. Dispositif selon les revendications 9 ou 10, **caractérisé en ce qu'**une liaison conductrice de la chaleur est prévue entre le bain de revêtement (16, 116) et les sources de lumière (20, 21, 120).

12. Dispositif selon les revendications 9 ou 10, **caractérisé en ce qu'**il présente un circuit extérieur d'eau de refroidissement qui permet de refroidir les sources de lumière (20, 21, 120) indépendamment du bain de revêtement (16, 116).

13. Dispositif selon l'une des revendications 9 à 12, **caractérisé en ce que** les sources de lumière (20, 21, 120) sont réparties dans le bain de revêtement (16, 116).

14. Dispositif selon l'une des revendications 9 à 13, **caractérisé en ce que** les sources de lumière (20, 21, 120) sont remplaçables sans intervention dans le bain de revêtement (16, 116) ni sur l'étanchéité de la cuve de revêtement (15, 115) qui reprend le bain de revêtement (16, 116).

15. Dispositif selon l'une des revendications 9 à 13, **caractérisé en ce que** les sources de lumière (20, 21, 120) sont dotées d'un filtre coloré (27) remplaçable qui permet d'adapter la longueur d'onde de la couleur de la lumière (22, 122) émise à celle du bain de revêtement (16, 116).
